# EUROPEAN PATENT APPLICATION

(11) **EP 4 636 550 A1**
(43) Date of publication of application: **22.10.2025**
(21) Application number: 25161886.4
(22) Date of filing: 05.03.2025
(51) Int. Cl.: G06F 3/041, G06F 3/044

(54) **DISPLAY DEVICE AND ELECTRONIC DEVICE INCLUDING DISPLAY DEVICE**

(30) Priority: 17.04.2024 KR 20240051287
(71) Applicant: Samsung Display Co., Ltd., Yongin-si, Gyeonggi-do 17113 (KR)
(72) Inventor: Yoo, Gi Na, 17113 Yongin-si, Gyeonggi-do (KR); Kim, Ju Yeon, 17113 Yongin-si, Gyeonggi-do (KR); Choi, Dong Hee, 17113 Yongin-si, Gyeonggi-do (KR)
(74) Representative: Gulde & Partner

(57) **Abstract**

A display device includes sub-pixel areas and a display layer including a light emitting element disposed in the sub-pixel areas, and an encapsulation layer disposed on the light emitting element. A sensor layer includes a sensor base layer and conductive pattern layers including first and second conductive pattern layers disposed on different layers from one another. The sensor layer includes an overlapped area where the first and second conductive pattern layers overlap each other, a non-overlapped area where either the first or second conductive patterns, but not both, is disposed, and a cutting area where the first and/or second conductive patterns is cut. The conductive pattern layers include a non-overlapped identification pattern portion disposed in the non-overlapped area, and an overlapped identification pattern portion disposed in the overlapped area.

## Description

### TECHNICAL FIELD

Various embodiments of the present disclosure relate to a display device and an electronic device including the display device.

### DISCUSSION OF THE RELATED ART

Display devices are often incorporated into electronic products for the purpose of providing an intuitive means of input and output. The display devices may include a light source such as an inorganic light emitting element or an organic light emitting element.

The display devices may include a display panel configured to display an image, and a sensing panel configured to sense the proximity and/or touch of an object such as a user's finger or a stylus pen. Here, the sensing panel may be used to determine a position of touch input provided from a user.

It is desirable for display devices to have good visibility, particularly in bright environments where light reflectance may be an issue.

### SUMMARY

The present invention relates to a display device, which includes sub-pixel areas. A display layer of the display device includes a light emitting element disposed in the sub-pixel areas, and an encapsulation layer disposed on the light emitting element. A sensor layer includes a sensor base layer and conductive pattern layers disposed on the sensor base layer. The conductive pattern layers include a first conductive pattern layer and a second conductive pattern layer disposed on different layers from one another. The sensor base layer is disposed on the encapsulation layer. The sensor layer includes an overlapped area where the first conductive pattern layer and the second conductive pattern layer overlap each other, a non-overlapped area where the first conductive pattern layer or the second conductive pattern layer, but not both, is disposed, and a cutting area where the first conductive pattern layer and/or the second conductive pattern layer is cut. The conductive pattern layers include a non-overlapped identification pattern portion disposed in the non-overlapped area, and an overlapped identification pattern portion disposed in the overlapped area.

The non-overlapped identification pattern portion may include a bump structure, and may correspond to a position of the cutting area.

The cutting area may include a plurality of cutting areas arranged in a matrix structure. The non-overlapped identification pattern portion may include a plurality of non-overlapped identification pattern portions arranged based on a position to which the matrix structure is shifted in a direction to correspond to the matrix structure.

The non-overlapped identification pattern portion may have a shape extending in two or more directions.

The non-overlapped identification pattern portion may include a first non-overlapped identification pattern portion formed of the first conductive pattern layer, and a second non-overlapped identification pattern portion formed of the second conductive pattern layer.

The overlapped area may include a point-type overlapped area. The overlapped identification pattern portion may include a point-type overlapped identification pattern portion formed in the point-type overlapped area. The point-type overlapped area may be an area where at least respective portions of the first conductive pattern layer and the second conductive pattern layer extend in different directions from one another and intersect with each other.

The point-type overlapped identification pattern portion might not overlap the sub-pixel area in a first direction, and might not overlap the sub-pixel area in a second direction different from the first direction.

The point-type overlapped identification pattern portion may include a plurality of point-type overlapped identification pattern portions sequentially arranged in the second direction.

The point-type overlapped identification pattern portion might not overlap the non-overlapped identification pattern portion in the first direction, and may overlap the non-overlapped identification pattern portion in the second direction.

A size of the point-type overlapped identification pattern portion may be less than a size of the non-overlapped identification pattern portion.

The point-type overlapped identification pattern portion may include protrusions extending in respective different directions.

The point-type overlapped identification pattern portion may have an "X" shape.

The point-type overlapped identification pattern portion may have a solidus shape or a reverse solidus shape.

The point-type overlapped identification pattern portion may include a first point-type overlapped identification pattern portion having the solidus shape, and a second point-type overlapped identification pattern portion having the reverse solidus shape. The first point-type overlapped identification pattern portion and the second point-type overlapped identification pattern portion may be alternately disposed in a direction.

The protrusions may be formed of the second conductive pattern layer.

The overlapped area may include a line-type overlapped area. The overlapped identification pattern portion may include a line-type overlapped identification pattern portion formed in the line-type overlapped area. The line-type overlapped area may be an area where at least respective portions of the first conductive pattern layer and the second conductive pattern layer extend in an identical direction and overlap each other.

The line-type overlapped identification pattern portion might not overlap the sub-pixel area in a first direction, and may overlap the sub-pixel area in a second direction different from the first direction.

The line-type overlapped identification pattern portion may include a plurality of line-type overlapped identification pattern portions sequentially arranged in the first direction and spaced apart from each other at regular intervals.

A size of the line-type overlapped identification pattern portion may be greater than a size of the non-overlapped identification pattern portion.

The line-type overlapped identification pattern portion may have a shape extending in two or more directions.

The line-type overlapped identification pattern portion may have a solidus shape or a reverse solidus shape.

The line-type overlapped identification pattern portion may include a first line-type overlapped identification pattern portion having the solidus shape, and a second line-type overlapped identification pattern portion having the reverse solidus shape. The first line-type overlapped identification pattern portion and the second line-type overlapped identification pattern portion may be alternately disposed in a particular direction.

The overlapped area may include a point-type overlapped area and a line-type overlapped area. The overlapped identification pattern portion may include a point-type overlapped identification pattern portion formed in the point-type overlapped area, and a line-type overlapped identification pattern portion formed in the line-type overlapped area. The point-type overlapped identification pattern portion and the line-type overlapped identification pattern portion may have different shapes.

The conductive pattern layers may form a first sensing electrode and a second sensing electrode. The first sensing electrode and the second sensing electrode may be physically spaced apart from each other with the cutting area interposed therebetween.

The sensor base layer may be disposed directly on the encapsulation layer.

The sub-pixel areas may include a first sub-pixel area providing light of a first color, a second sub-pixel area providing light of a second color, and a third sub-pixel area providing light of a third color. The first sub-pixel area and the second sub-pixel area may be adjacent to each other in a first direction, and the third sub-pixel area may be adjacent to the first sub-pixel area and the second sub-pixel area in a second direction different from the first direction. The third sub-pixel area may have a surface area that is greater than a surface area of the first sub-pixel area or the second sub-pixel area.

For example, the display device may further include sub-pixels forming sub-pixel areas each providing light of a color. Sensing electrodes are disposed on different layers from one another, are formed of a first conductive pattern layer and a second conductive pattern layer that do not overlap the sub-pixel areas, and include a mesh structure formed by the second conductive pattern layer. At least a portion of the second conductive pattern layer is cut in cutting areas. The first conductive pattern layer and the second conductive pattern layer include non-overlapped identification pattern portions formed in an area where the first conductive pattern layer and the second conductive pattern layer do not overlap each other, and overlapped identification pattern portions formed in an area where the first conductive pattern layer and the second conductive pattern layer overlap each other. The cutting areas are arranged in a matrix structure based on a first direction and a second direction different from the first direction. The non-overlapped identification pattern portions are disposed adjacent to the cutting areas and correspond to the matrix structure. The overlapped identification pattern portions do not overlap the cutting areas in either the first direction or the second direction.

The electronic device as described above may further include a processor configured to provide input image data. Said display device is configured to display an image based on the input image data, and including sub-pixel areas. Further, a power supply is configured to supply power to the display device. The display device includes a display layer including a light emitting element disposed in the sub-pixel areas and a sensor layer including conductive pattern layers including a first conductive pattern layer and a second conductive pattern layer that are disposed in different layers from one another. The sensor layer includes an overlapped area where the first conductive pattern layer and the second conductive pattern layer overlap each other, a non-overlapped area where either the first conductive pattern layer or the second conductive pattern layer, but not both, is disposed, and a cutting area where the first conductive pattern layer and/or the second conductive pattern layer is cut. The conductive pattern layers include a non-overlapped identification pattern portion disposed in the non-overlapped area, and an overlapped identification pattern portion disposed in the overlapped area.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings.
FIG. 1 is a diagram illustrating a display device in accordance with an embodiment.
FIG. 2 is a schematic cross-sectional view illustrating a stacked structure of the display device in accordance with an embodiment.
FIG. 3 is a schematic cross-sectional view illustrating a display layer in accordance with an embodiment.
FIG. 4 is a schematic cross-sectional view illustrating a sensor layer in accordance with an embodiment.
FIG. 5 is a schematic block diagram illustrating areas of the sensor layer in accordance with an embodiment.
FIGS. 6 and 7 are schematic plan views each illustrating sensing electrodes in accordance with an embodiment.
FIG. 8 is a schematic cross-sectional view illustrating a sensor layer in accordance with an embodiment.
FIG. 9 is a schematic cross-sectional view illustrating the display device in accordance with an embodiment.
FIGS. 10 to 12 are schematic plan views illustrating a display device including a point-type overlapped identification pattern portion.
FIG. 13 is a schematic cross-sectional view taken along line C-C' of FIG. 10.
FIGS. 14 to 16 are schematic plan views illustrating a display device including a line-type overlapped identification pattern portion.
FIG. 17 is a schematic cross-sectional view taken along line D-D' of FIGS. 14 and 15.
FIG. 18 is a schematic plan view illustrating a display device including first line-type overlapped identification pattern portions.
FIG. 19 is a schematic block diagram illustrating an electronic device including a display device in accordance with an embodiment.
FIG. 20 is a schematic diagram illustrating an example where the electronic device of FIG. 19 is implemented as a smartphone.
FIG. 21 is a schematic diagram illustrating an example where the electronic device of FIG. 19 is implemented as a tablet computer.

### DETAILED DESCRIPTION

As the present disclosure allows for various changes and numerous embodiments, particular embodiments will be illustrated in the drawings and described in detail in the written description. However, this is not necessarily intended to limit the present disclosure to particular modes of practice, and it is to be appreciated that all changes, equivalents, and substitutes that do not depart from the technical scope of the present disclosure are encompassed in the present disclosure.

It will be understood that, although the terms "first", "second", etc. may be used herein to describe various elements, these elements should not be limited by these terms. These terms are used to distinguish one element from another element. For instance, a first element discussed below could be termed a second element without departing from the teachings of the present disclosure. Similarly, the second element could also be termed the first element. In the present disclosure, the singular forms are intended to include the plural forms as well, unless the context clearly indicates otherwise.

It will be further understood that the terms "comprise", "include", "have", etc. when used in the present disclosure, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, when it is expressed that a first part such as a layer, a film, a region, or a plate is formed on a second part, the surface of the second part on which the first part is formed is not necessarily limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

Various embodiments of the present disclosure relate to a display device and an electronic device including the display device. Hereinafter, a display device and an electronic device including the display device in accordance with an embodiment will be described with reference to the attached drawings.

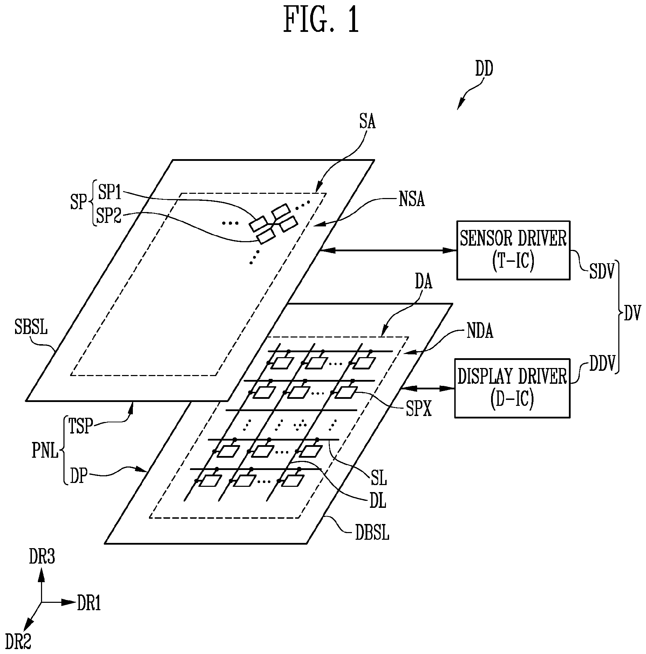

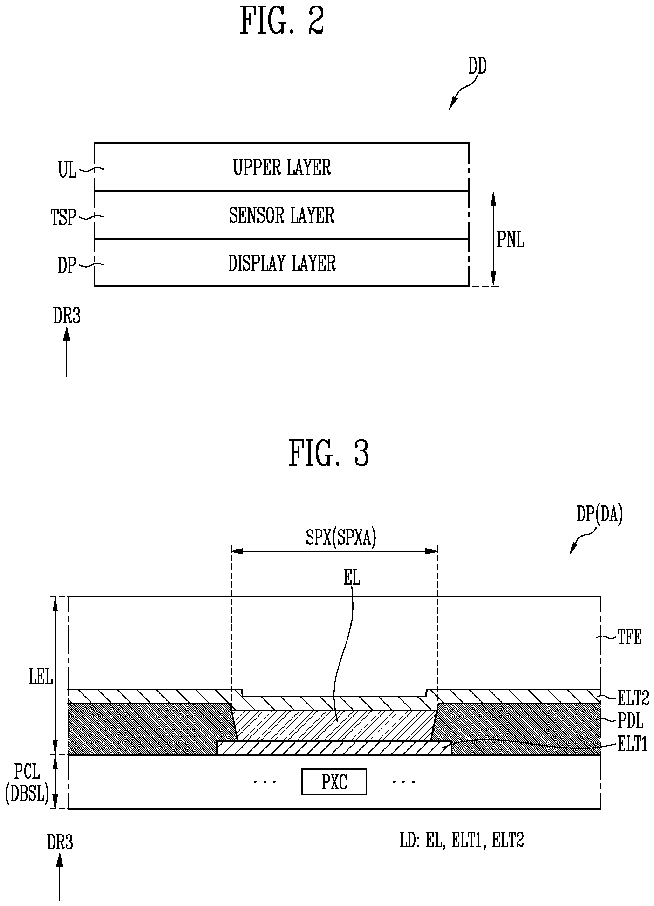

FIG. 1 is a diagram illustrating a display device DD in accordance with an embodiment. FIG. 2 is a schematic cross-sectional view illustrating a stacked structure of the display device in accordance with an embodiment.

Referring to FIGS. 1 and 2, the display device DD may be configured to provide (e.g., emit) light. The display device DD may include a panel PNL, and a driving circuit component DV configured to drive the panel PNL. The display device DD may include an upper layer UL.

The panel PNL may include a display layer DP configured to display an image, and a sensor layer TSP configured to sense user input (e.g., touch input of a user's finger and/or a stylus pen).

The display layer DP may be referred to as a display panel. The sensor layer TSP may be referred to as a sensing panel.

The panel PNL may include sub-pixels SPX and sensing electrodes SP. In an embodiment, the sub-pixels SPX may display an image in units of each display frame period. The sensing electrodes SP may sense input (e.g., touch input) from the user in units of each sensing frame period. The sensing frame period and the display frame period may be independent from each other, or may be different from each other. The sensing frame period and the display frame period may be synchronized with each other, or may be asynchronous.

The sensor layer TSP may acquire information about a touch input from the user. The sensing electrodes SP may include a first sensing electrode SP1 configured to provide a first sensing signal, and a second sensing electrode SP2 configured to provide a second sensing signal. In an embodiment (e.g., using a mutual capacitance scheme), the first sensing electrode SP1 may be a transmitter (Tx) pattern electrode, and the second sensing electrode SP2 may be a receiver (Rx) pattern electrode. Information about the touch input (or a touch event) may mean information including a position or the like of a touch provided from the user. However, the present disclosure is not necessarily limited to the foregoing. For example, in an embodiment (e.g., using a self-capacitance scheme), the sensing electrodes SP may be configured of one type of sensing electrodes without distinction between the first sensing electrode SP1 and the second sensing electrode SP2.

The driving circuit component DV may include a display driver DDV (D-IC) configured to drive the display layer DP, and a sensor driver SDV (T-IC) configured to drive the sensor layer TSP.

The display layer DP may include a display base layer DBSL, and sub-pixels SPX provided on the display base layer DBSL. The sub-pixels SPX may be disposed in the display area DA.

The display base layer DBSL (or the display device DD) may include a display area DA displaying an image, and a non-display area NDA which is an area other than the display area DA. In an embodiment, the display area DA may be disposed in a central portion of the display layer DP, and the non-display area NDA may be disposed adjacent to a periphery of the display area DA. However, the present disclosure is not necessarily limited to the aforementioned example.

The display base layer DBSL may be a base substrate or a base component for supporting the display device DD. The display base layer DBSL may be a rigid substrate made of glass. The display base layer DBSL may be formed of a silicon substrate. The display base layer DBSL may be a flexible substrate capable of bending, folding, rolling, etc. to a noticeable extent without cracking or otherwise sustaining damage. In this case, the display base layer DBSL may include insulating material such as polymer resin, e.g., polyimide. However, the present disclosure is not necessarily limited to a particular example.

Scan lines SL, data lines DL, and sub-pixels SPX electrically connected to the scan lines SL and the data lines DL may be disposed in the display area DA. The sub-pixels SPX may be selected by scan signals each of which has a turn-on level, and which are supplied from the scan lines SL, may be supplied with data signals from the data lines DL, and may emit light having luminance corresponding to the data signals. Consequently, an image corresponding to the data signals may be displayed in the display area DA.

Various lines and/or an internal circuit component which are connected to the sub-pixels SPX in the display area DA may be disposed in the non-display area NDA. For example, a plurality of lines for supplying various power voltages and control signals to the display area DA may be disposed in the non-display area NDA.

The display layer DP may output visible information (e.g., an image). In an embodiment, the display layer DP may include an organic light emitting diode or a light emitting diode including inorganic material. However, the present disclosure is not necessarily limited to a particular example. Hereinafter, for convenience of description, the following will be based on an embodiment where the display layer DP includes an organic light emitting diode.

The sensor layer TSP includes a sensor base layer SBSL, and may include sensing electrodes SP formed on the sensor base layer SBSL. The sensing electrodes SP may be disposed in a sensing area SA on the sensor base layer SBSL.

The sensor base layer SBSL (or the display device DD) may include the sensing area SA capable of sensing touch input or the like, and a non-sensing area NSA formed around a periphery of the sensing area SA. In an embodiment, the sensing area SA may overlap at least a part of the display area DA. For example, the sensing area SA may be an area corresponding to the display area DA (e.g., an area overlapping the display area DA). The non-sensing area NSA may be an area corresponding to the non-display area NDA (e.g., an area overlapping the non-display area NDA). In this case, when touch input or the like is provided on the display area DA, the touch input may be detected through the sensor layer TSP.

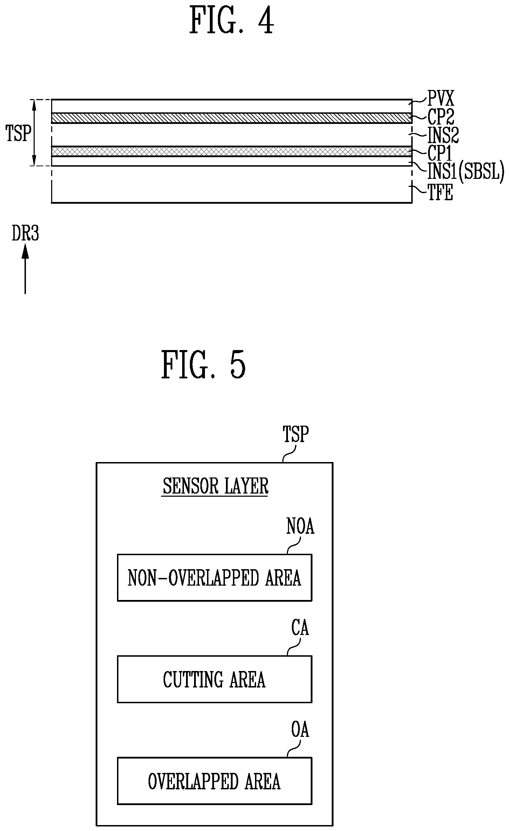

The sensor base layer SBSL may include one or more insulating layers (e.g., a first insulating layer INS1 (refer to FIG. 4)). For example, the first insulating layer INS1 provided to form the sensor base layer SBSL may be disposed on the display layer DP, thus forming a base on which the sensing electrodes SP can be formed. The sensor base layer SBSL is disposed (e.g., disposed directly) on an encapsulation layer TFE (refer to FIG. 3) of the display layer DP. For example, after the display layer DP is fabricated, the sensor layer TSP may be formed by sequentially forming layers for forming the sensor layer TSP on the encapsulation layer TFE formed over the display layer DP. In this case, process convenience may be increased.

The sensing area SA may be an area (i.e., an active area of the sensor) capable of responding to touch input. The sensor layer TSP may acquire information about input provided from the user. The sensor layer TSP may recognize the touch input. The sensor layer TSP may use a capacitive sensing scheme to recognize the touch input. The sensor layer TSP may sense the touch input in a mutual capacitance scheme, or may sense the touch input in a self-capacitance scheme.

In an embodiment, each of the first sensing electrodes SP1 may extend in a first direction DR1. The first sensing electrodes SP1 may be arranged in a second direction DR2. In an embodiment, each of the second sensing electrodes SP2 may extend in the second direction DR2. The second sensing electrodes SP2 may be arranged in the first direction DR1. The second direction DR2 may differ from the first direction DR1. For example, the second direction DR2 may be a direction perpendicular to the first direction DR1.

In the non-sensing area NSA of the sensor layer TSP, sensing lines may electrically connect the sensing electrodes SP with the sensor driver SDV or the like.

The driving circuit component DV may include a display driver DDV configured to drive the display layer DP, and a sensor driver SDV configured to drive the sensor layer TSP.

The display driver DDV may be electrically connected to the display layer DP and configured to drive the sub-pixels SPX. The sensor driver SDV may be electrically connected to the sensor layer TSP and configured to drive the sensor layer TSP.

The upper layer UL may be disposed on the sensor layer TSP. Light provided from the display layer DP may be outputted to the outside through the upper layer UL.

The display layer DP, in accordance with an embodiment, will be described with reference to FIG. 3. FIG. 3 is a schematic cross-sectional view illustrating the display layer DP in accordance with an embodiment.

Referring to FIG. 3, the display layer DP may include a pixel-circuit layer PCL, and a light-emitting-element layer LEL.

The pixel-circuit layer PCL may include a pixel circuit PXC configured to drive light emitting elements LD. The pixel-circuit layer PCL may include a display base layer DBSL, conductive layers provided to form pixel circuits PXC, and insulating layers disposed between the conductive layers.

The pixel circuit PXC may include a pixel element (e.g., a driving transistor). The pixel circuit PXC may be electrically connected to the light emitting elements LD, and may provide electrical signals to allow the light emitting elements LD to emit light.

The light-emitting-element layer LEL may be disposed on the pixel-circuit layer PCL. In an embodiment, the light-emitting-element layer LEL may include a light emitting element LD, a pixel defining layer PDL, and an encapsulation layer TFE.

The light emitting element LD may be disposed on the pixel-circuit layer PCL. In an embodiment, the light emitting element LD may include a first electrode ELT1, an emission structure EL, and a second electrode ELT2. In an embodiment, the emission structure EL may be disposed in an area defined by the pixel defining layer PDL. The pixel defining layer PDL may be adjacent to a periphery of the emission structure EL. One surface of the emission structure EL may be electrically connected to the first electrode ELT1. The other surface of the emission structure EL may be electrically connected to the second electrode ELT2.

The first electrode ELT1 may be an anode electrode for the emission structure EL. The second electrode ELT2 may be a common electrode (or a cathode electrode) for the emission structure EL. In an embodiment, the first electrode ELT1 and the second electrode ELT2 may include an electrically conductive material. For example, the first electrode ELT1 may include an electrically conductive material that is also reflective of light. The second electrode ELT2 may include transparent conductive material. However, the present disclosure is not necessarily limited to the aforementioned example.

The emission structure EL may include a plurality of layers. For example, the emission structure EL may include a plurality of emission structures each including a hole transport component, an emission layer (or a light generating layer), and an electron transport component. Each of the layers that form the emission structure may include an organic material and, in an embodiment, may further include an inorganic material such as a metal-containing compound or quantum dot.

The hole transport component may include a multilayer structure having a plurality of layers respectively including different materials from one another. For example, the hole transport component may include a hole injection layer and a hole transport layer and, in an embodiment, may further include an auxiliary emission layer, an electron blocking layer, and the like.

The emission layer may include material capable of emitting light of a particular color. The emission layer may include a host and a dopant. The host of the emission layer may be emission material capable of capturing carriers (electrons and holes) for light generation, thus inducing efficient exciton generation. The dopant may include a phosphorescent dopant or a fluorescent dopant. In an embodiment, examples of the dopant are not specifically limited to what has been described herein. In an embodiment, the dopant may include an organic material, and may include metal complex or the like.

The electron transport component may include a multilayer structure having a plurality of layers respectively including different materials. The electron transport component may include an electron injection layer and an electron transport layer and, in an embodiment, may further include an electron buffer layer, a hole blocking layer, and so on.

The emission structure EL may form a sub-pixel SPX. The emission structure EL may form a sub-pixel area SPXA configured to emit light of a color. In a plan view, an area of the emission structure EL and the sub-pixel area SPXA may correspond to each other. For example, each emission structure EL may correspond to an associated sub-pixel area SPXA.

The pixel defining layer PDL may be disposed on the pixel-circuit layer PCL, and may define a position at which the emission structure EL is disposed. The pixel defining layer PDL may include organic material or inorganic material. For example, the pixel defining layer PDL may include a plurality of layers each including inorganic material. However, the present disclosure is not necessarily limited to the aforementioned example.

The encapsulation layer TFE is disposed on the light emitting element LD (e.g., the second electrode ELT2). The encapsulation layer TFE may offset a step difference formed by the light emitting element LD and the pixel defining layer PDL. The encapsulation layer TFE may include a plurality of insulating layers configured to cover the light emitting element LD. In an embodiment, the encapsulation layer TFE may include an inorganic layer and an organic layer. For example, the encapsulation layer TFE may have a structure in which a first inorganic layer, an organic layer, and a second inorganic layer are sequentially arranged. However, the present disclosure is not necessarily limited to the aforementioned example. In an embodiment, the encapsulation layer TFE may be formed of a thin film encapsulation layer.

The sensor layer TSP, in accordance with an embodiment, will be described with reference to FIGS. 4 to 8.

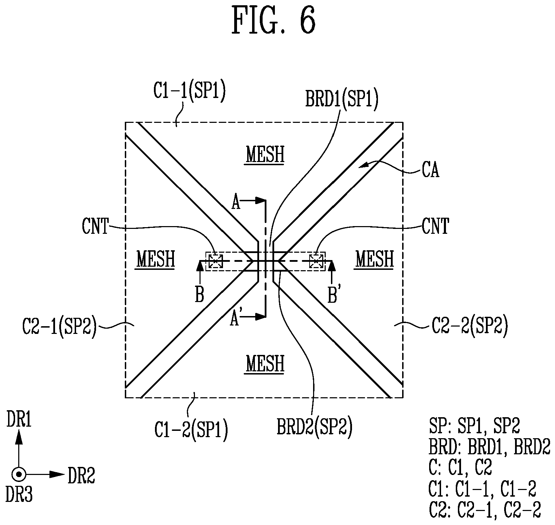

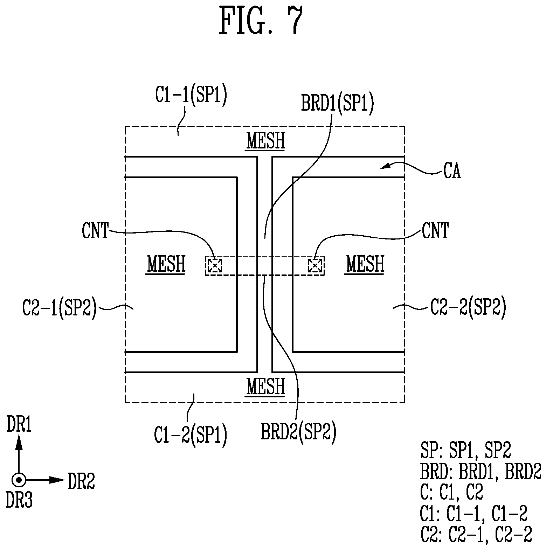

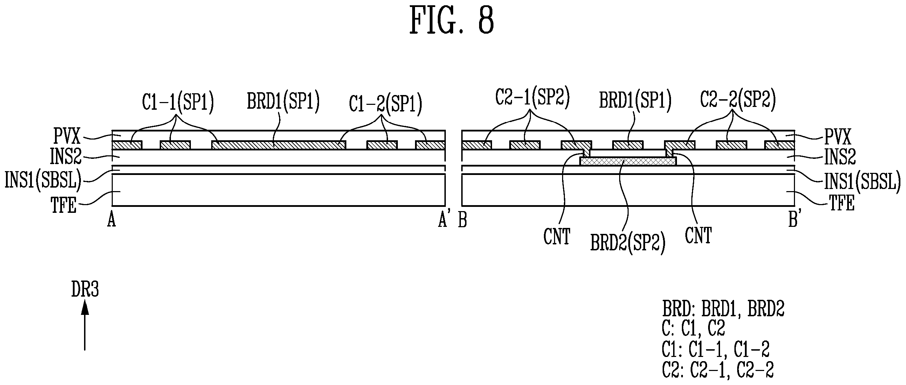

FIG. 4 is a schematic cross-sectional view illustrating the sensor layer TSP in accordance with an embodiment. FIG. 5 is a schematic block diagram illustrating areas of the sensor layer TSP in accordance with an embodiment. FIGS. 6 and 7 are schematic plan views each illustrating sensing electrodes SP in accordance with an embodiment. FIGS. 6 and 7 each illustrate a schematic planar structure of an area where the first sensing electrode SP1 and the second sensing electrode SP2 are adjacent to each other. FIGS. 6 and 7 each illustrate a planar structure of the first sensing electrode SP1 and the second sensing electrode SP2 each having a certain shape in accordance with an embodiment. FIG. 8 is a schematic cross-sectional view illustrating the sensor layer TSP in accordance with an embodiment. FIG. 8 illustrates a schematic cross-sectional structure taken along line A-A' of FIG. 6, and a cross-sectional structure taken along line B-B' of FIG. 6.

Referring to FIGS. 4 to 8, the sensor layer TSP is disposed (e.g., disposed directly) on the encapsulation layer TFE. The sensor layer TSP may include a first insulating layer INS1 (as e.g. sensor base layer SBSL), a first conductive pattern layer CP1, a second insulating layer INS2, a second conductive pattern layer CP2, and a passivation layer PVX.

The first conductive pattern layer CP1 and the second conductive pattern layer CP2 are disposed on different layers. The first conductive pattern layer CP1 and the second conductive pattern layer CP2 may partially overlap each other in a plan view.

The plane defined in this specification may extend in the first direction DR1 and the second direction DR2, and may be defined based on the plane on which the display base layer DBSL is disposed. In an embodiment, the third direction DR3 may correspond to the thickness direction of the display base layer DBSL. The third direction DR3 may correspond to a light output direction of the display device DD.

In an embodiment, the first conductive pattern layer CP1 and the second conductive pattern layer CP2 may be patterned in an area to form sensing electrodes SP. For example, at least a portion of each of the first conductive pattern layer CP1 and the second conductive pattern layer CP2, or the second conductive pattern layer CP2 may form the first sensing electrode SP1. At least a portion of each of the first conductive pattern layer CP1 and the second conductive pattern layer CP2, or the second conductive pattern layer CP2 may form the second sensing electrode SP2.

The first insulating layer INS1 may be disposed (e.g., disposed directly) on the encapsulation layer TFE. The first insulating layer INS1 may form the sensor base layer SBSL and thus provide an area in which the first conductive pattern layer CP1, the second insulating layer INS2, the second conductive pattern layer CP2, and the passivation layer PVX are disposed.

The first conductive pattern layer CP1 may be disposed on the first insulating layer INS1. The second conductive pattern layer CP2 may be disposed on the second insulating layer INS2. The first conductive pattern layer CP1 and the second conductive pattern layer CP2 may be spaced apart from each other with the second insulating layer INS2 interposed therebetween.

Each of the first conductive pattern layer CP1 and the second conductive pattern layer CP2 may include a single metallic layer or multiple metallic layers. Each of the first conductive pattern layer CP1 and the second conductive pattern layer CP2 may include gold (Au), silver (Ag), aluminum (Al), molybdenum (Mo), chromium (Cr), titanium (Ti), nickel (Ni), neodymium (Nd), copper (Cu), platinum (Pt), and the like, or an alloy thereof. In an embodiment, the first conductive pattern layer CP1 and the second conductive pattern layer CP2 may include a silver nanowire (AgNW), indium tin oxide (ITO), indium zinc oxide (IZO), indium gallium zinc oxide (IGZO), Aluminum zinc oxide (AZO), indium tin zinc oxide (ITZO), zinc oxide (ZnO), tin oxide (SnO₂), carbon nanotubes, and/or graphene.

The second insulating layer INS2 may be disposed on the first conductive pattern layer CP1. The second insulating layer INS2 may be interposed between the first conductive pattern layer CP1 and the second conductive pattern layer CP2. The passivation layer PVX may be disposed on the second conductive pattern layer CP2.

The first insulating layer INS1 may include one or more of an inorganic material and an organic material. The second insulating layer INS2 may include one or more of an inorganic material and an organic material. In embodiments, the passivation layer PVX may include an organic material. The inorganic material may include silicon nitride (SiNₓ), silicon oxide (SiOₓ), silicon oxynitride (SiOₓN_{y}), and/or aluminum oxide (AlOₓ). The organic material may include acryl resin, epoxy resin, phenol resin, polyamide resin, and/or polyimide resin. However, the present disclosure is not necessarily limited to the aforementioned example.

The sensor layer TSP includes a non-overlapped area NOA, a cutting area CA, and an overlapped area OA.

The non-overlapped area NOA may be an area where the first conductive pattern layer CP1 and the second conductive pattern layer CP2 do not overlap each other, and may include an area where the first conductive pattern layer CP1 is disposed, and an area where the second conductive pattern layer CP2 is disposed. For example, the non-overlapped area NOA may include an area where the first conductive pattern layer CP1 is disposed without the second conductive pattern layer CP2 being disposed, and an area where the second conductive pattern layer CP2 is disposed without the first conductive pattern layer CP1 being disposed. The non-overlapped area NOA might not overlap the sub-pixel areas SPXA, in a plan view.

The cutting area CA is an area formed by cutting any one of the first conductive pattern layer CP1 and the second conductive pattern layer CP2. For example, the cutting area CA may be an area formed by cutting at least a portion of the second conductive pattern layer CP2 to electrically separate the first and second sensing electrodes SP1 and SP2 from each other. For example, the first and second sensing electrodes SP1 and SP2 may be adjacent to each other with the cutting area CA interposed therebetween, and may be physically spaced apart from each other. The cutting area CA might not overlap the sub-pixel areas SPXA, in a plan view.

The overlapped area OA is an area where the first conductive pattern layer CP1 and the second conductive pattern layer CP2 overlap each other, in a plan view. In an embodiment, the first conductive pattern layer CP1 and the second conductive pattern layer CP2 may be disposed so as not to overlap the sub-pixel areas SPXA in a plan view. The first conductive pattern layer CP1 and the second conductive pattern layer CP2 may partially overlap each other, thus defining the overlapped area OA. The overlapped area OA might not overlap the sub-pixel areas SPXA, in a plan view.

Hence, the sensor layer TSP may include areas that are distinctly defined based on the structures of the first conductive pattern layer CP1 and the second conductive pattern layer CP2. Experimentally, the amount of reflection of external light applied from the outside of the display device DD may vary in the non-overlapped area NOA, the cutting area CA, and the overlapped area OA. In this case, there may be a risk of reduced visibility due to external light.

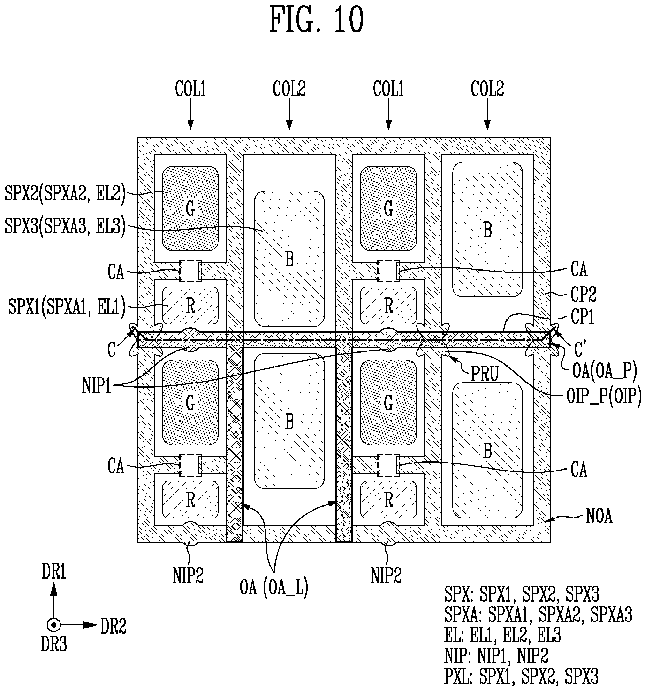

However, in accordance with an embodiment, identification pattern portions NIP and OIP (refer to FIG. 10) may compensate for a difference in structure of the first conductive pattern layer CP1 and the second conductive pattern layer CP2 between the non-overlapped area NOA, the cutting area CA, and the overlapped area OA of the sensor layer TSP. Accordingly, the risk of deteriorating the visibility due to reflection of external light can be reduced, thereby providing a display device DD with increased display quality. Details of the identification pattern portions NIP and OIP will be described with reference to FIG. 10 and subsequent drawings.

The sensing electrodes SP may include a cell C and a bridge BRD. The cell C may have a relatively large surface area. The bridge BRD may have a relatively small surface area. Cells C adjacent to each other may be electrically connected to each other by the bridge BRD. The cell C may include a first cell C1 and a second cell C2. The bridge BRD may include a first bridge BRD1 and a second bridge BRD2.

In an embodiment, the first cell C1 and the second cell C2 may be formed of the second conductive pattern layer CP2. The first bridge BRD1 may be formed of the second conductive pattern layer CP2. A portion of the second bridge BRD2 may be formed of the first conductive pattern layer CP1. The other portion of the second bridge BRD2 may be formed of the second conductive pattern layer CP2. However, the present disclosure is not necessarily limited to the foregoing example. For example, the first cell C1 and the second cell C2 may be formed of the first conductive pattern layer CP1. The first bridge BRD1 may be formed of the first conductive pattern layer CP1. A portion of the second bridge BRD2 may be formed of the second conductive pattern layer CP2. The other portion of the second bridge BRD2 may be formed of the first conductive pattern layer CP1.

In an embodiment, the sensing electrodes SP may form a mesh structure. The cells C and the bridges BRD may form a mesh structure. For example, the second conductive pattern layer CP2 for forming the sensing electrodes SP may be patterned according to a mesh structure.

The first sensing electrode SP1 may have a structure in which the first cells C1 each having a relatively large surface area and the first bridge BRD1 having a relatively small surface area are connected to each other. For example, the first cell C1 may include a 1-1-th cell C1-1 and a 1-2-th cell C1-2. The first bridge BRD1 may electrically connect the 1-1-th cell C1-1 and the 1-2-th cell C1-2 to each other.

The second sensing electrode SP2 may have a structure in which the second cells C2 each having a relatively large surface area and the second bridge BRD2 having a relatively small surface area are connected to each other. For example, the second cell C2 may include a 2-1-th cell C2-1 and a 2-2-th cell C2-2. The second bridge BRD2 may electrically connect the 2-1-th cell C2-1 and the 2-2-th cell C2-2 to each other.

In an embodiment, the second bridge BRD2 may be electrically connected to the 2-1-th cell C2-1 through a contactor CNT, and may be electrically connected to the 2-2-th cell C2-2 through another contactor CNT. Hence, the second bridge BRD2 that is disposed on a layer different from that of the second cell C2 may electrically connect the 2-1-th cell C2-1 and the 2-2-th cell C2-2 to each other through the contactor CNT. In an embodiment, the contactor CNT may pass through the second insulating layer INS2.

The first cell C1 and the second cell C2 each may have a diamond shape as a whole (refer to FIG. 6). However, the shape of each of the first cell C1 and the second cell C2 is not necessarily particularly limited to the foregoing shape. For example, each of the first cell C1 and the second cell C2 may have an overall rectangular shape as a whole (refer to FIG. 7).

In accordance with an embodiment, the cutting area CA may be defined between the sensing electrodes SP, which are electrically spaced apart from each other. For example, the first sensing electrodes SP1 and the second sensing electrodes SP2 may be adjacent to each other with the cutting area CA interposed therebetween. The cutting area CA may be defined in an area between the first sensing electrodes SP1 and the second sensing electrodes SP2. For example, the cutting area CA may be disposed (or formed, or defined) between the 1-1-th cell C1-1 and the 1-2-th cell C1-2 and the 2-1-th cell C2-1 and the 2-2-th cell C2-2. The cutting area CA may be disposed (or formed, or defined) between the first bridge BRD1 and the 2-1-th cell C2-1 and the 2-2-th cell C2-2.

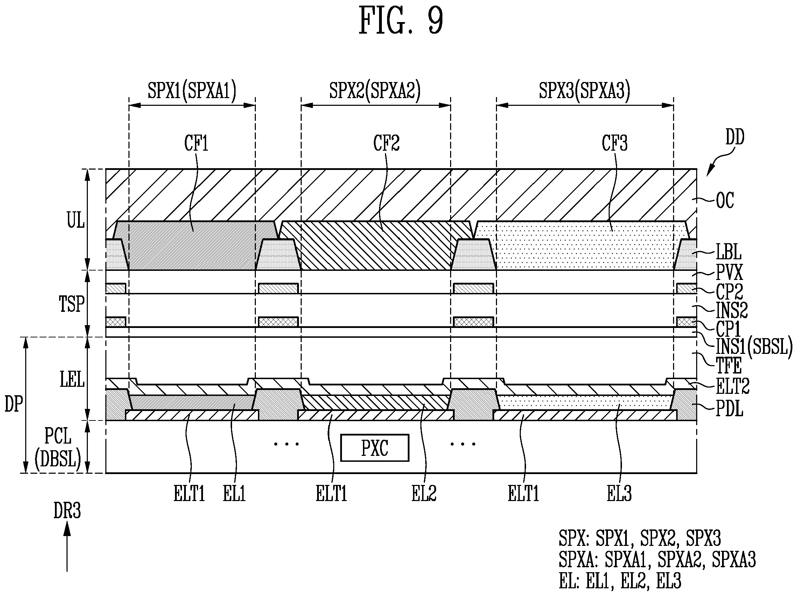

Hereinafter, a cross-sectional structure of the display device DD in accordance with an embodiment will be described with reference to FIG. 9.

FIG. 9 is a schematic cross-sectional view illustrating the display device DD in accordance with an embodiment.

Referring to FIG. 9, the emission structure EL may include a first emission structure EL1 included in the first sub-pixel SPX1, a second emission structure EL2 included in the second sub-pixel SPX2, and a third emission structure EL3 included in the third sub-pixel SPX3. The first emission structure EL1 may emit light of a first color (e.g., red), and may form a first sub-pixel area SPXA1. The second emission structure EL2 may emit light of a second color (e.g., green), and may form a second sub-pixel area SPXA2. The third emission structure EL3 may emit light of a third color (e.g., blue), and may form a third sub-pixel area SPXA3.

In the sensor layer TSP, the first conductive pattern layer CP1 and the second conductive pattern layer CP2 may be disposed on different layers, thus forming the structure of the sensing electrodes SP.

The upper layer UL may be disposed on the sensor layer TSP. The upper layer UL may transmit at least a portion of light provided from the emission structure EL. In an embodiment, the upper layer UL may include a light blocking layer LBL, color filters CF1 to CF3, and an overcoat layer OC. However, the structure of the upper layer UL is not necessarily limited to the aforementioned example.

The light blocking layer LBL may overlap the first conductive pattern layer CP1 and the second conductive pattern layer CP2, in a plan view. The light blocking layer LBL may include light blocking material, such as a material that may reflect or absorb light. Alternatively, in an embodiment, the light blocking layer LBL may be formed by overlapping the first to third color filters CF1 to CF3.

The color filters CF1 to CF3 may include a first color filter CF1 disposed in the first sub-pixel area SPXA1, a second color filter CF2 disposed in the second sub-pixel area SPXA2, and a third color filter CF3 disposed in the third sub-pixel area SPXA3.

The first color filter CF1 may be disposed in the first sub-pixel area SPXA1. The first color filter CF1 may include color filter material (e.g., pigment or dye) for allowing light of the first color (e.g., red) to selectively pass therethrough.

The second color filter CF2 may be disposed in the second sub-pixel area SPXA2. The second color filter CF2 may include color filter material (e.g., pigment or dye) for allowing light of the second color (e.g., green) to selectively pass therethrough.

The third color filter CF3 may be disposed in the third sub-pixel area SPXA3. The third color filter CF3 may include color filter material (e.g., pigment or dye) for allowing light of the third color (e.g., blue) to selectively pass therethrough.

The overcoat layer OC may be disposed on the color filters CF1 to CF3. The overcoat layer OC may include various materials suitable for protecting layers disposed thereunder from foreign substances. For example, the overcoat layer OC may include an inorganic insulating layer and/or an organic insulating layer. For instance, the overcoat layer OC may include epoxy, but the embodiments are not necessarily limited thereto.

In an embodiment, the sub-pixel areas SPXA may be different from each other in size (or surface area). The surface areas of the first sub-pixel area SPXA1, the second sub-pixel area SPXA2, and the third sub-pixel area SPXA3 may be different from each other. For example, the surface area of the third sub-pixel area SPXA3 may be greater than the surface area of the second sub-pixel area SPXA2. The surface area of the second sub-pixel area SPXA2 may be greater than the surface area of the first sub-pixel area SPXA1. In an embodiment, the surface areas of some sub-pixel areas SPXA may be different from that of the other sub-pixel areas SPXA, so that an emission efficiency deviation between the sub-pixels SPX by colors can be compensated for.

A cross-sectional structure of the display device DD is not necessarily limited to the foregoing example. For example, in accordance with an embodiment, the display device DD may further include a color conversion layer including a quantum-dot capable of converting the color of light applied thereto. The color conversion layer may be disposed on the light emitting element LD. The position of the color conversion layer is not necessarily particularly limited to what is described herein.

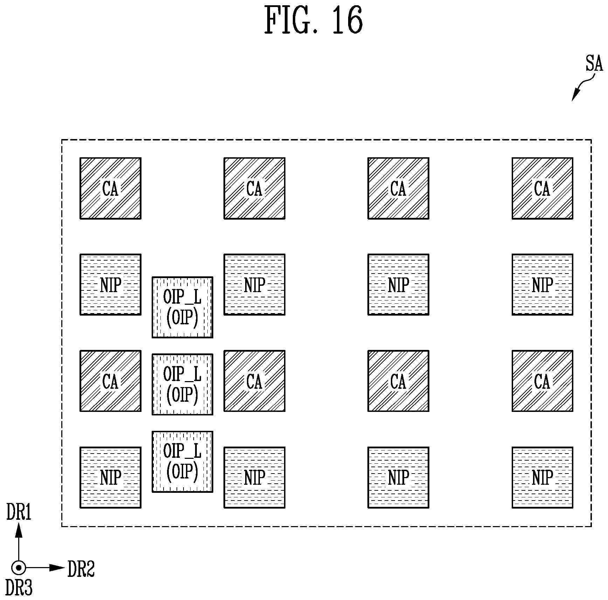

The display device DD including the identification pattern portions NIP and OIP will be described with reference to FIGS. 10 to 18. To the extent that an element is not described in detail with respect to this figure, it may be understood that the element is at least similar to a corresponding element that has been described elsewhere within the present disclosure.

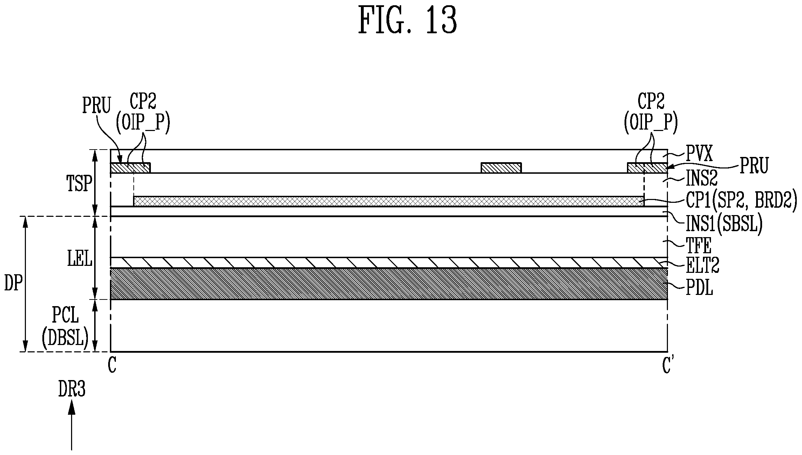

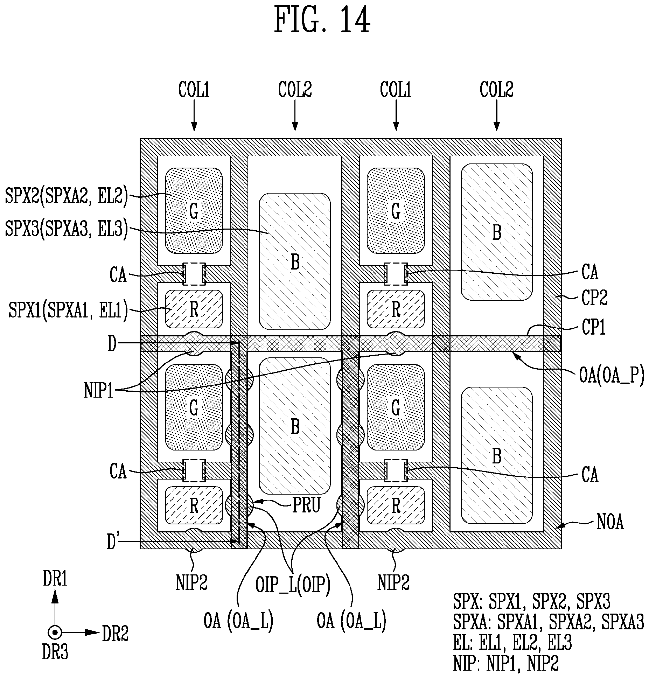

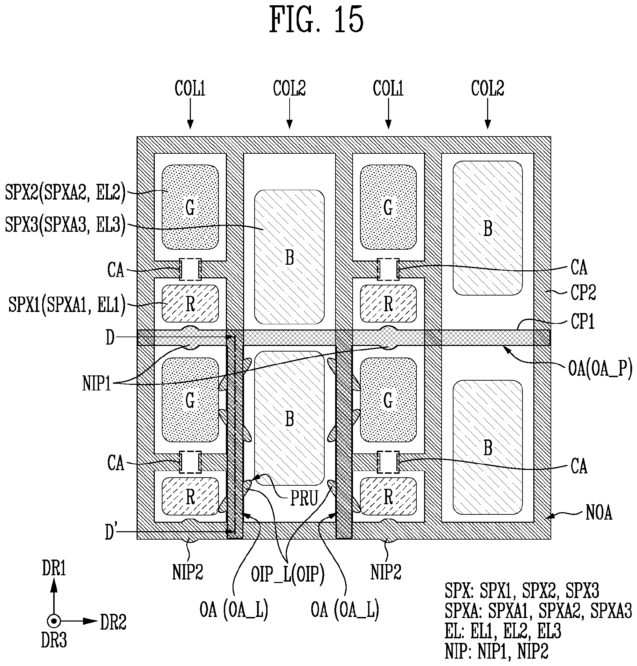

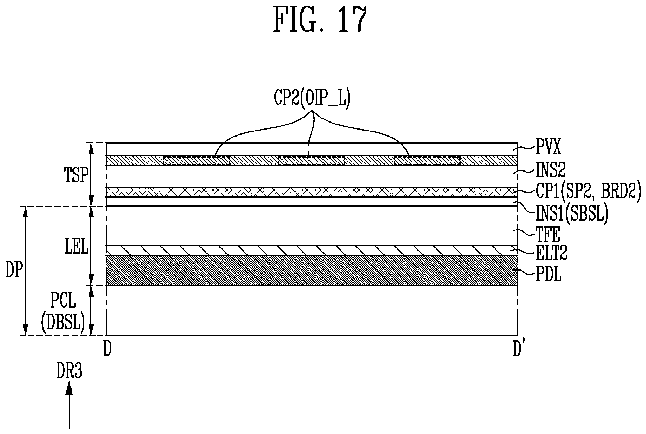

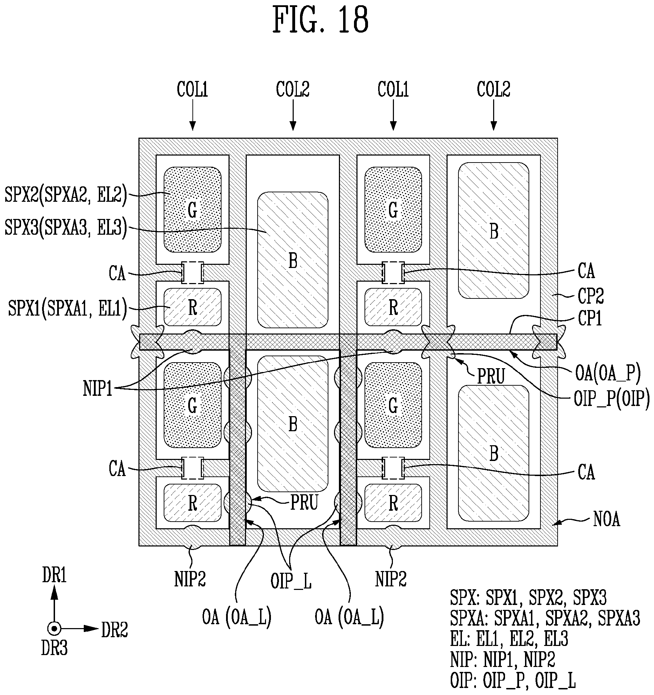

FIGS. 10 to 18 are schematic diagrams each illustrating the display device DD including the identification pattern portions NIP and OIP in accordance with an embodiment. FIGS. 10 to 12 are schematic plan views illustrating a display device including a point-type overlapped identification pattern portion. FIG. 13 is a schematic cross-sectional view taken along line C-C' of FIG. 10. FIGS. 14 to 16 are schematic plan views illustrating a display device including a line-type overlapped identification pattern portion. FIG. 17 is a schematic cross-sectional view taken along line D-D' of FIGS. 14 and 15. FIG. 18 is a schematic plan view illustrating a display device including first line-type overlapped identification pattern portions.

According to an embodiment, the sub-pixels SPX may be arranged in various structures. Hereinafter, the description is based on an embodiment where the sub-pixels SPX are arranged according to an S-stripe structure. In the following description, a position relationship of the sub-pixels SPX1, SPX2, and SPX3 may correspond to a position relationship of the sub-pixel areas SPXA1, SPXA2, and SPXA3 and/or the emission structures EL1, EL2, and EL3.

The first sub-pixel SPX1 and the second sub-pixel SPX2 may form a first pixel column COL1. The first sub-pixel SPX1 and the second sub-pixel SPX2 may be sequentially disposed in the first direction DR1. First sub-pixels SPX1 and second sub-pixels SPX2 may be alternately disposed in the first direction DR1. The first sub-pixel SPX1 and the second sub-pixel SPX2 may be disposed in the first pixel column COL1 without the third sub-pixel SPX3 being disposed therein.

The third sub-pixel SPX3 may form a second pixel column COL2. Third sub-pixels SPX3 may be sequentially disposed in the first direction DR1. The third sub-pixel SPX3 may be disposed in the second pixel column COL2 without the first sub-pixel SPX1 and the second sub-pixel SPX2 being disposed therein.

The first pixel column COL1 and the second pixel column COL2 may be adjacent to each other in the second direction DR2. For example, the first sub-pixel SPX1 may be adjacent to the third sub-pixel SPX3 in the second direction DR2. The second sub-pixel SPX2 may be adjacent to the third sub-pixel SPX3 in the second direction DR2.

First pixel columns COL1 and second pixel columns COL2 may be alternately arranged in the second direction DR2. For example, each second pixel column COL2 may be disposed between two first pixel column COL1. Each first pixel column COL1 may be disposed between two second pixel columns COL2.

The first sub-pixel SPX1 and the second sub-pixel SPX2 that are adjacent to each other in the first direction DR1 and the third sub-pixel SPX3 that is adjacent to the first and second sub-pixels SPX1 and SPX2 in the second direction DR2 may form a pixel PXL (or a pixel unit).

In an embodiment, first and second conductive pattern layers CP1 and CP2 may be disposed in peripheral portions of the sub-pixel areas SPXA. For example, the second conductive pattern layer CP2 may be disposed around the sub-pixel SPX (or the sub-pixel areas SPXA). The second conductive pattern layer CP2 may enclose at least a portion of the sub-pixel areas SPXA, in a plan view.

As described above, the identification pattern portions NIP and OIP may compensate for a difference in structure of the first conductive pattern layer CP1 and the second conductive pattern layer CP2 between the non-overlapped area NOA, the cutting area CA, and the overlapped area OA of the sensor layer TSP.

In accordance with an embodiment, the cutting area CA may include a plurality of cutting areas CA. In accordance with an embodiment, a non-overlapped identification pattern portion NIP may include a plurality of non-overlapped identification pattern portions NIP. The plurality of non-overlapped identification pattern portions NIP may correspond to positions of the plurality of cutting areas CA.

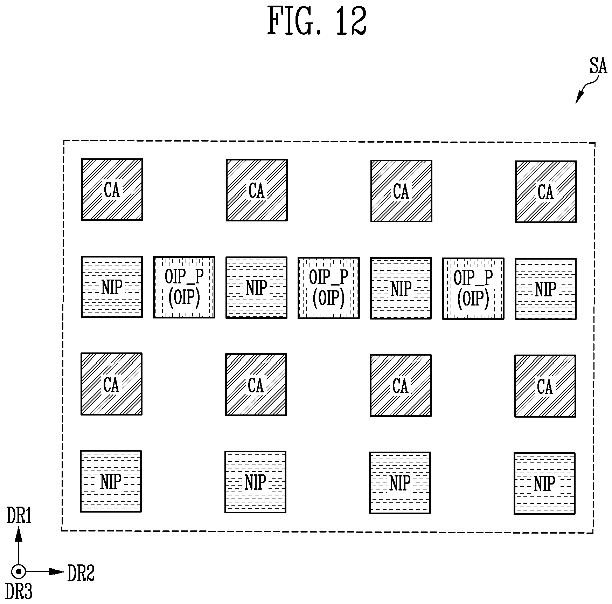

For example, the plurality of non-overlapped identification pattern portions NIP may overlap the plurality of cutting areas CA in the first direction DR1. The plurality of non-overlapped identification pattern portions NIP may be disposed at respective positions shifted in the first direction DR1 from the positions at which the plurality of cutting areas CA are disposed (refer to FIG. 12, etc.). For example, the plurality of cutting areas CA may be arranged in a matrix structure based on the first direction DR1 and the second direction DR2. The plurality of non-overlapped identification pattern portions NIP may be arranged based on positions to which the matrix structure is shifted in the first direction DR1.

In an embodiment, the cutting area CA and the non-overlapped identification pattern portion NIP may be adjacent to each other in the first direction DR1 with any one of the sub-pixels SPXA interposed therebetween. Each of the cutting area CA and the non-overlapped identification pattern portion NIP may be disposed between the first sub-pixel area SPXA1 and the second sub-pixel area SPXA2 based on the first direction DR1. The cutting area CA and the non-overlapped identification pattern portion NIP may be adjacent to each other with the first sub-pixel area SPXA1 or the second sub-pixel area SPXA2 interposed therebetween.

In this case, even when the cutting area CA separates the first and second sensing electrodes SP1 and SP2 from each other, the non-overlapped identification pattern portion NIP may compensate for a difference in reflection of external light, thereby mitigating the risk of reduced visibility.

In an embodiment, the non-overlapped identification pattern portion NIP may include a bump structure. For example, the non-overlapped identification pattern portion NIP may include portions that protrude in a planar direction in some areas of the first and second conductive pattern layers CP1 and CP2. In this case, the non-overlapped identification pattern portion NIP may have a shape extending in two or more directions. As described above, even when the cutting area CA separates the first and second sensing electrodes SP1 and SP2 from each other, the non-overlapped identification pattern portion NIP may change the reflection pattern of external light and compensate for a difference in reflection of the external light. For example, the non-overlapped identification pattern portion NIP may have a circular shape or an elliptical shape, in a plan view. However, the present disclosure is not necessarily limited to the aforementioned example.

In an embodiment, the non-overlapped identification pattern portion NIP may be formed of at least one of the first and second conductive pattern layers CP1 and CP2. For example, the non-overlapped identification pattern portion NIP may include a first non-overlapped identification pattern portion NIP1 formed of the first conductive pattern layer CP1, and a second non-overlapped identification pattern portion NIP2 formed of the second conductive pattern layer CP2.

In an embodiment, the overlapped area OA may include a point-type overlapped area OA_P and a line-type overlapped area OA_L.

In some areas in the sensing area SA, the first conductive pattern layer CP1 and the second conductive pattern layer CP2 may extend in the same direction, and an area where the first conductive pattern layer CP1 and the second conductive pattern layer CP2 overlap each other may extend in a line shape. Accordingly, the area where the first conductive pattern layer CP1 and the second conductive pattern layer CP2 extend parallel to each other and overlap each other may be defined as a line-type overlapped area OA_L.

In some areas in the sensing area SA, the first conductive pattern layer CP1 and the second conductive pattern layer CP2 may extend in different directions, and the first conductive pattern layer CP1 and the second conductive pattern layer CP2 may intersect with each other. Accordingly, the area where the first conductive pattern layer CP1 and the second conductive pattern layer CP2 intersect with each other may be defined as a point-type overlapped area OA_P.

Referring to FIGS. 10 to 18, the display device DD may include an overlapped identification pattern portion OIP formed in the overlapped area OA to enhance the visibility of the display device DD. In an embodiment, the overlapped identification pattern portion OIP might not overlap the cutting area CA in either the first direction DR1 or the second direction DR2. For example, the overlapped identification pattern portion OIP might not overlap the cutting area CA in the first direction DR1.

In an embodiment, the reflectance of external light in the overlapped area OA may differ from the reflectance of external light in the non-overlapped area NOA and the cutting area CA. In an embodiment, the overlapped identification pattern portion OIP may be formed in the overlapped area OA, thereby compensating for a difference in external light reflectance between areas.

The overlapped identification pattern portion OIP may have different shapes depending on the shape of the overlapped area OA. Hereinafter, an embodiment including the overlapped identification pattern portion OIP having a different structure for each area of the overlapped area OA will be described.

FIGS. 10 to 13 illustrate an embodiment in which the display device DD includes a non-overlapped identification pattern portion NIP corresponding to the cutting area CA, and further includes a point-type overlapped identification pattern portion OIP_P formed in the point-type overlapped area OA_P.

In an embodiment, the overlapped identification pattern portion OIP may include a point-type overlapped identification pattern portion OIP_P. The point-type overlapped identification pattern portion OIP_P may be referred to as a first overlapped identification pattern portion.

The point-type overlapped identification pattern portion OIP_P may be disposed in the point-type overlapped area OA_P. The point-type overlapped identification pattern portion OIP_P may be formed in an area where the first and second conductive pattern layers CP1 and CP2 extending in different directions intersect with each other.

The point-type overlapped identification pattern portion OIP_P might not overlap the sub-pixel areas SPXA in the first direction DR1. The point-type overlapped identification pattern portion OIP_P might not overlap the sub-pixel areas SPXA in the second direction DR2.

The point-type overlapped identification pattern portion OIP_P may include a plurality of point-type overlapped identification pattern portions OIP_P. The number of point-type overlapped identification pattern portions OIP_P formed around the sub-pixel areas SPXA is not necessarily particularly limited to what is described herein. In an embodiment, the plurality of point-type overlapped identification pattern portions OIP_P may be sequentially arranged in the second direction DR2.

The point-type overlapped identification pattern portion OIP_P may overlap the non-overlapped identification pattern portion NIP (e.g., the first non-overlapped identification pattern portion NIP1) in the second direction DR2 (refer to FIG. 12, etc.), and may not overlap the non-overlapped identification pattern portion NIP (e.g., the first non-overlapped identification pattern portion NIP1 and the second non-overlapped identification pattern portion NIP2) in the first direction DR1. In an embodiment, the point-type overlapped identification pattern portion OIP_P might not overlap a portion of the non-overlapped identification pattern portion NIP (e.g., the second non-overlapped identification pattern portion NIP2) in the second direction DR2.

The point-type overlapped identification pattern portion OIP_P may have a relatively small surface area. For example, the point-type overlapped identification pattern portion OIP_P may have a surface area that is smaller than that of the non-overlapped identification pattern portion NIP. For example, the point-type overlapped identification pattern portion OIP_P may include a protrusion PRU having a surface area that is smaller than that of the non-overlapped identification pattern portion NIP. The protrusion PRU may be formed around the point-type overlapped area OA_P, and may be formed of any one of the first and second conductive pattern layers CP1 and CP2. For example, in an embodiment, the protrusion PRU may be formed of the second conductive pattern layer CP2.

In an embodiment, the point-type overlapped identification pattern portion OIP_P may have a structure protruding from the point-type overlapped area OA_P in two or more directions. For example, the protrusion PRU may include a plurality of protrusions PRU. The plurality of protrusions PRU may extend from the point-type overlapped area OA_P in two or more different directions. In an embodiment, the aforementioned different directions may differ from the first direction DR1 and the second direction DR2.

For example (refer to FIG. 10), the plurality of protrusions PRU may respectively extend in four directions, whereby the point-type overlapped identification pattern portion OIP_P may have an approximately "X" shape. For example, the plurality of protrusions PRU may include first to fourth protrusions. In the point-type overlapped area OA_P, the first protrusion may extend in an upper right direction, the second protrusion may extend in a lower right direction, the third protrusion may extend in a lower left direction, and the fourth protrusion may extend in an upper left direction.

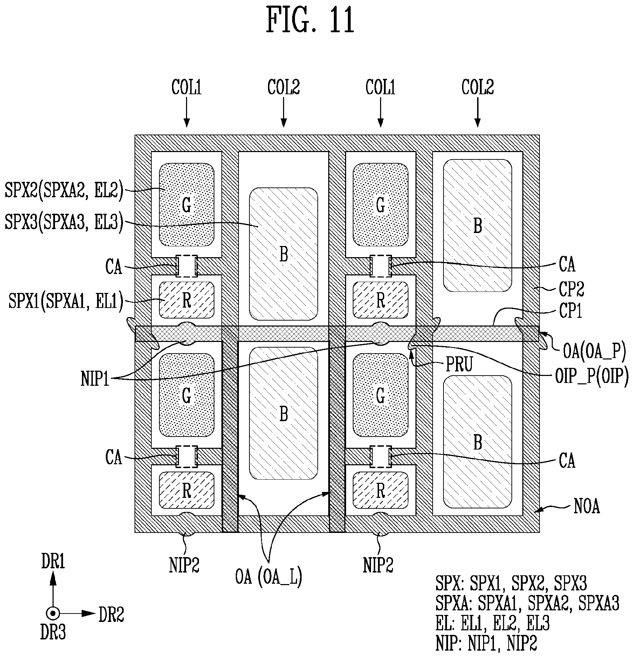

In an example (refer to FIG. 11), the plurality of protrusions PRU may respectively extend in two directions. Hence, the point-type overlapped identification pattern portion OIP_P may have a shape that is at least approximately solidus, such as a slash shape (e.g., a "/" shape) and/or a shape that is at least approximately reverse solidus, such as a backslash shape (e.g., a left-right inverted shape of "/"). The solidus shape of the point-type overlapped identification pattern portion OIP_P may be understood as an oblique ellipse shape and the reverse solidus shape may be understood as the mirror image of said oblique ellipse shape. For example, the plurality of protrusions PRU may include first and second protrusions, and in the point-type overlapped area OA_P, the first protrusion may extend in an upper right direction, and the second protrusion may extend in a lower left direction. Alternatively, the plurality of protrusions PRU may include first and second protrusions, and in the point-type overlapped area OA_P, the first protrusion may extend in an upper left direction, and the second protrusion may extend in a lower right direction. In an embodiment, solidus-shaped point-type overlapped identification pattern portions OIP_P (e.g., first point-type overlapped identification pattern portions) and reverse solidus-shaped point-type overlapped identification pattern portions OIP_P (e.g., second point-type overlapped identification pattern portions) may be alternately disposed in a direction (e.g., the second direction DR2).

Experimentally, in the case where the first and second conductive pattern layers CP1 and CP2 overlap in the point-type overlapped area OA_P, reflected light from applied external light in the point-type overlapped area OA_P may have a relatively low light quantity, and there may be a risk of the reflected light being perceived in the form of a point.

In an embodiment, the point-type overlapped identification pattern portion OIP_P may include protrusions PRU extending in two or more directions. Hence, the protrusions PRU may disperse reflected light generated from the point-type overlapped area OA_P. For example, the protrusions PRU may disperse a reflective angle of reflected light generated in the point-type overlapped area OA_P. In this case, the intensity of the reflected light with a relatively low light quantity may be reduced, so that the risk of external light reflection being perceived in the point-type overlapped area OA_P can be reduced.

FIGS. 14 to 17 illustrate an embodiment in which the display device DD includes a non-overlapped identification pattern portion NIP corresponding to the cutting area CA, and further includes a line-type overlapped identification pattern portion OIP_L formed in the line-type overlapped area OA_L.

In an embodiment, the overlapped identification pattern portion OIP may include a line-type overlapped identification pattern portion OIP_L. The line-type overlapped identification pattern portion OIP_L may be referred to as a second overlapped identification pattern portion.

The line-type overlapped identification pattern portion OIP_L may be disposed in the line-type overlapped area OA_L. The line-type overlapped identification pattern portion OIP_L may be formed in an area where the first and second conductive pattern layers CP1 and CP2 extending in the same direction overlap each other.

The line-type overlapped identification pattern portion OIP_L might not overlap the sub-pixel area SPXA in the first direction DR1. The line-type overlapped identification pattern portion OIP_L may overlap the sub-pixel area SPXA in the second direction DR2.

The line-type overlapped identification pattern portion OIP_L may include a plurality of line-type overlapped identification pattern portions OIP_L. The number of line-type overlapped identification pattern portions OIP_L formed around the sub-pixel areas SPXA is necessarily not particularly limited to what is described herein. In an embodiment, the plurality of line-type overlapped identification pattern portions OIP_L may be sequentially arranged in the first direction DR1. In an embodiment, the plurality of line-type overlapped identification pattern portions OIP_L may be spaced apart from each other at the same interval. However, the present disclosure is not necessarily limited to the aforementioned example.

The line-type overlapped identification pattern portions OIP_L may partially overlap the non-overlapped identification pattern portion NIP (e.g., the first and second non-overlapped identification pattern portions NIP1 and NIP2) or the cutting area CA in the second direction DR2. However, the present disclosure is not necessarily limited to the aforementioned example. The line-type overlapped identification pattern portions OIP_L might not overlap the non-overlapped identification pattern portion NIP (e.g., the first and second non-overlapped identification pattern portions NIP1 and NIP2) or the cutting area CA in the second direction DR2.

In an embodiment (refer to FIG. 14), the line-type overlapped identification pattern portion OIP_L may include a bump structure in a manner similar to that of the non-overlapped identification pattern portion NIP. For example, the line-type overlapped identification pattern portion OIP_L may include portions that protrude in a planar direction in some areas of the first and second conductive pattern layers CP1 and CP2. In this case, the line-type overlapped identification pattern portion OIP_L may have a shape extending in two or more directions. Accordingly, even when reflection of external light occurs in the line-type overlapped area OA_L, the line-type overlapped identification pattern portion OIP_L may change the reflection pattern of external light and compensate for a difference in reflection of the external light. For example, the line-type overlapped identification pattern portion OIP_L may have a circular shape or an elliptical shape, in a plan view. However, the present disclosure is not necessarily limited to the aforementioned example. In an embodiment, the size of the line-type overlapped identification pattern portion OIP_L may be greater than that of the non-overlapped identification pattern portion NIP.

Alternatively, in an embodiment (refer to FIG. 15), the line-type overlapped identification pattern portion OIP_L may include a protruding structure similar to that of the point-type overlapped identification pattern portion OIP_P described above. For example, the line-type overlapped identification pattern portion OIP_L may have protrusions PRU protruding in two or more directions in the line-type overlapped area OA_L. The protrusions PRU may extend in two or more different directions in the line-type overlapped area OA_L. In an embodiment, the aforementioned different directions may differ from the first direction DR1 and the second direction DR2. For example, the line-type overlapped identification pattern portion OIP_L may approximately have a solidus shape (e.g., a "/" shape) and/or a reverse solidus shape (e.g., a left-right inverted shape of "/"). In an embodiment, solidus-shaped line-type overlapped identification pattern portions OIP_L (e.g., first line-type overlapped identification pattern portions) and reverse solidus-shaped line-type overlapped identification pattern portions OIP_L (e.g., second line-type overlapped identification pattern portions) may be alternately disposed in a direction (e.g., the first direction DR1). However, the present disclosure is not necessarily limited to the aforementioned example. For example, the line-type overlapped identification pattern portions OIP_L may have an approximately "X" shape.

Experimentally, in the case where the first and second conductive pattern layers CP1 and CP2 overlap in the line-type overlapped area OA_L, reflected light from applied external light in the line-type overlapped area OA_L may have a relatively high light quantity.

In an embodiment, in the line-type overlapped area OA_L, the line-type overlapped identification pattern portions OIP_L may be sequentially disposed along the overlapped area. Accordingly, the quantity of reflected light generated from the line-type overlapped area OA_L may be reduced, thereby reducing the risk of external light reflection being perceived in the line-type overlapped area OA_L. Furthermore, in an embodiment, since the size of the line-type overlapped identification pattern portion OIP_L may be greater than the size of the non-overlapped identification pattern portion NIP, the quantity of light generated in the line-type overlapped area OA_L may be further reduced.

FIG. 18 illustrates an embodiment in which the display device DD includes a non-overlapped identification pattern portion NIP corresponding to the cutting area CA, and includes both the point-type overlapped identification pattern portion OIP_P and the line-type overlapped identification pattern portion OIP_L.

For example, the point-type overlapped identification pattern portion OIP_P may be formed in the point-type overlapped area OA_P of the overlapped area OA. The line-type overlapped identification pattern portion OIP_L may be formed in the line-type overlapped area OA_L of the overlapped area OA. In the present embodiment, the point-type overlapped identification pattern portion OIP_P may have a structure described above with reference to FIGS. 10 to 13. The line-type overlapped identification pattern portion OIP_L may have a structure described above with reference to FIGS. 14 to 17. In an embodiment, the line-type overlapped identification pattern portion OIP_L and the point-type overlapped identification pattern portion OIP_P may have different shapes.

In the present embodiment, all reflection patterns of external light corresponding to different types of overlapped areas OA may be compensated for. Accordingly, a display device DD with further increased visibility may be provided.

Hereinafter, an electronic device 1000 including the display device DD in accordance with an embodiment will be described.

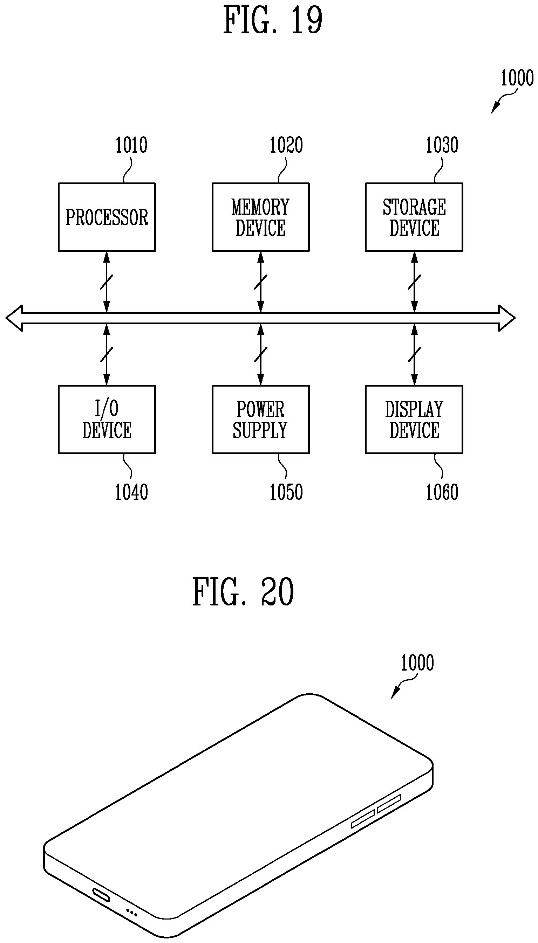

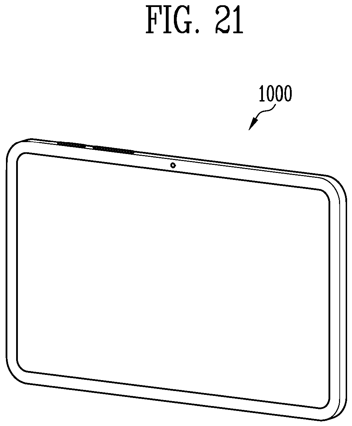

FIG. 19 is a schematic block diagram illustrating an electronic device 1000 including a display device in accordance with an embodiment. FIG. 20 is a schematic diagram illustrating an example where the electronic device 1000 of FIG. 19 is implemented as a smartphone. FIG. 21 is a schematic diagram illustrating an example where the electronic device 1000 of FIG. 19 is implemented as a tablet computer.

Referring to FIGS. 19 to 21, the electronic device 1000 may include a processor 1010, a memory device 1020, a storage device 1030, an input/output (I/O) device 1040, a power supply 1050, and a display device 1060 (DD). The display device 1060 may be the display device DD of FIG. 1. The electronic device 1000 may further include various ports for communication with a video card, a sound card, a memory card, a USB device, or other systems. In an embodiment, as illustrated in FIG. 20, the electronic device 1000 may be implemented as a smartphone. In an embodiment, as illustrated in FIG. 21, the electronic device 1000 may be implemented as a tablet computer. However, the aforementioned examples are illustrative, and the electronic device 1000 is not necessarily limited to the aforementioned examples. For example, the electronic device 1000 may be implemented as a cellular phone, a video phone, a smartpad, a smartwatch, a navigation device for vehicles, a computer monitor, a laptop computer, a head-mounted display device, or the like.

The processor 1010 may perform specific calculations or tasks. In an embodiment, the processor 1010 may be a micro processor, a central processing unit, an application processor, or the like. The processor 1010 may be connected to other components through an address bus, a control bus, a data bus, and the like. In an embodiment, the processor 1010 may be connected to an expansion bus such as a peripheral component interconnect (PCI) bus. In an embodiment, the processor 1010 may provide input image data to the display device 1060. Hence, the display device 1060 may display an image based on the input image data provided from the processor 1010.

The memory device 1020 may store data needed to perform the operation of the electronic device 1000. For example, the memory device 1020 may include non-volatile memory devices such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM) device, and a ferroelectric random access memory (FRAM) device, and/or volatile memory devices such as a dynamic random access memory (DRAM) device, a static random access memory (SRAM) device, a mobile DRAM device, and so on.

The storage device 1030 may include a solid state drive (SSD), a hard disk drive (HDD), a CD-ROM, or the like.

The I/O device 1040 may include input devices such as a keyboard, a keypad, a touchpad, a touch screen, and a mouse, and output devices such as a speaker and a printer. In an embodiment, the display device 1060 may be included in the I/O device 1040.

The power supply 1050 may supply power needed to perform the operation of the electronic device 1000. For example, the power supply 1050 may be a power management integrated circuit (PMIC). In an embodiment, the power supply 1050 may supply power to the display device 1060.

The display device 1060 may display an image corresponding to visual information of the electronic device 1000. The display device 1060 may be connected to other components through the buses or other communication links.

Various embodiments of the present disclosure may provide a display device with increased visibility and an electronic device including the display device.

While various exemplary embodiments have been described above, those skilled in the art will appreciate that various modifications, additions and substitutions are possible, without departing from the scope of the present disclosure.

## Claims

1. A display device (DD), comprising:
a plurality of sub-pixel areas (SPXA);
a display layer (DP) including a light emitting element (LD) disposed in the sub-pixel areas (SPXA), and an encapsulation layer (TFE) disposed on the light emitting element (LD); and
a sensor layer (TSP) including a sensor base layer (SBSL) and conductive pattern layers (CP1, CP2) disposed on the sensor base layer (SBSL), the conductive pattern layers (CP1, CP2) including a first conductive pattern layer (CP1) and a second conductive pattern layer (CP2) disposed on different layers from one another,
wherein the sensor base layer (SBSL) is disposed on the encapsulation layer (TFE),
wherein the sensor layer (TSP) includes an overlapped area (OA) where the first conductive pattern layer (CP1) and the second conductive pattern layer (CP2) overlap each other, a non-overlapped area (NOA) where either the first conductive pattern layer (CP1) or the second conductive pattern layer (CP2), but not both, is disposed, and a cutting area (CA) where the first conductive pattern layer (CP1) and/or the second conductive pattern layer (CP2) is cut, and
wherein the conductive pattern layers (CP1, CP2) include a non-overlapped identification pattern portion (NIP) disposed in the non-overlapped area (NOA), and an overlapped identification pattern portion (OIP) disposed in the overlapped area (OA).

2. The display device (DD) according to claim 1, wherein the non-overlapped identification pattern portion (NIP) includes a bump structure, and corresponds to a position of the cutting area (CA),
wherein the cutting area (CA) includes a plurality of cutting areas arranged in a matrix structure, and
wherein the non-overlapped identification pattern portion (NIP) comprises a plurality of non-overlapped identification pattern portions (NIP1, NIP2) arranged based on a position to which the matrix structure is shifted in a direction to correspond to the matrix structure.

3. The display device (DD) according to claim 1 or 2, wherein the non-overlapped identification pattern portion (NIP) has a shape extending in two or more directions.

4. The display device (DD) according to one of the preceding claims, wherein the non-overlapped identification pattern portion (NIP) comprises a first non-overlapped identification pattern portion (NIP1) formed of the first conductive pattern layer (CP1), and a second non-overlapped identification pattern portion (NIP2) formed of the second conductive pattern layer (CP2).

5. The display device (DD) according to at least one of the preceding claims,
wherein the overlapped area (OA) includes a point-type overlapped area (OA_P), wherein the overlapped identification pattern portion (OIP) includes a point-type overlapped identification pattern portion (OIP_P) formed in the point-type overlapped area (OA_P),
wherein the point-type overlapped area (OA_P) is an area where at least respective portions of the first conductive pattern layer (CP1) and the second conductive pattern layer (CP2) extend in different directions from one another and intersect with each other,
wherein the point-type overlapped identification pattern portion (OIP_P) does not overlap the sub-pixel area (SPXA) in a first direction, and does not overlap the sub-pixel area (SPXA) in a second direction different from the first direction, and
wherein the point-type overlapped identification pattern portion (OIP_P) comprises a plurality of point-type overlapped identification pattern portions sequentially arranged in the second direction.

6. The display device (DD) according to claim 5, wherein the point-type overlapped identification pattern portion (OIP_P) does not overlap the non-overlapped identification pattern portion (NIP) in the first direction, and does overlap the non-overlapped identification pattern portion (NIP) in the second direction.

7. The display device (DD) according to claim 5 or 6, wherein a size of the point-type overlapped identification pattern portion (OIP_P) is less than a size of the non-overlapped identification pattern portion (NIP),
wherein the point-type overlapped identification pattern portion (OIP_P) comprises protrusions extending in respective different directions, and
wherein the point-type overlapped identification pattern (OIP_P) portion has an "X" shape.

8. The display device (DD) according to claim 7, wherein the point-type overlapped identification pattern portion (OIP_P) has a solidus shape or a reverse solidus shape,
wherein the point-type overlapped identification pattern portion (OIP_P) comprises a first point-type overlapped identification pattern portion having the solidus shape, and a second point-type overlapped identification pattern portion having the reverse solidus shape, and
wherein the first point-type overlapped identification pattern portion and the second point-type overlapped identification pattern portion are alternately disposed in a particular direction.

9. The display device (DD) according to claim 7, wherein the protrusions are formed of the second conductive pattern layer (CP2).

10. The display device (DD) according to claim 1,
wherein the overlapped area (OA) includes a line-type overlapped area (OA_L),
wherein the overlapped identification pattern portion (OIP) includes a line-type overlapped identification pattern portion (OIP_L) formed in the line-type overlapped area (OA_L),
wherein the line-type overlapped area (OA_L) is an area where at least respective portions of the first conductive pattern layer (CP1) and the second conductive pattern layer (CP2) extend in an identical direction and overlap each other,
wherein the line-type overlapped identification pattern portion (OIP_L) does not overlap the sub-pixel area (SPXA) in a first direction, and does overlap the sub-pixel area (SPXA) in a second direction different from the first direction, and
wherein the line-type overlapped identification pattern portion (OIP_L) comprises a plurality of line-type overlapped identification pattern portions sequentially arranged in the first direction and spaced apart from each other at regular intervals.

11. The display device (DD) according to claim 10, wherein a size of the line-type overlapped identification pattern portion (OIP_L) is greater than a size of the non-overlapped identification pattern portion (NIP).

12. The display device (DD) according to one of claims 10 or 11, wherein the line-type overlapped identification pattern portion (OIP_L) has a shape extending in two or more directions.

13. The display device (DD) according to at least one of claims 10 to 12, wherein the line-type overlapped identification pattern portion (OIP_L) has a solidus shape or a reverse solidus shape,
wherein the line-type overlapped identification pattern portion (OIP_L) comprises a first line-type overlapped identification pattern portion having the solidus shape, and a second line-type overlapped identification pattern portion having the reverse solidus shape, and
wherein the first line-type overlapped identification pattern portion and the second line-type overlapped identification pattern portion are alternately disposed in a particular direction.

14. The display device (DD) according to claim 1,
wherein the overlapped area includes a point-type overlapped area (OA_P) and a line-type overlapped area (OA_L),
wherein the overlapped identification pattern portion (OIP) comprises a point-type overlapped identification pattern portion (OIP_P) formed in the point-type overlapped area (OA_P), and a line-type overlapped identification pattern portion (OIP_L) formed in the line-type overlapped area (OA_L), and
wherein the point-type overlapped identification pattern portion (OIP_P) and the line-type overlapped identification pattern portion (OIP_L) have different shapes.

15. The display (DD) device according to at least one of the preceding claims,
wherein the conductive pattern layers (CP1, CP2) form a first sensing electrode (SP1) and a second sensing electrode (SP2),
wherein the first sensing electrode (SP1) and the second sensing electrode (SP2) are physically spaced apart from each other with the cutting area (CA) interposed therebetween,
wherein the sensor base layer (SBSL) is disposed directly on the encapsulation layer (TFE),
wherein the sub-pixel areas (SPXA) include a first sub-pixel area (SPXA1) providing light of a first color, a second sub-pixel area (SPXA2) providing light of a second color, and a third sub-pixel area (SPXA3) providing light of a third color,
wherein the first sub-pixel area (SPXA1) and the second sub-pixel area (SPXA2) are adjacent to each other in a first direction, and the third sub-pixel area (SPXA3) is adjacent to the first sub-pixel area (SPXA1) and the second sub-pixel area (SPXA2) in a second direction different from the first direction, and
wherein the third sub-pixel area (SPXA3) has a surface area that is greater than a surface area of the first sub-pixel area (SPXA1) or the second sub-pixel area (SPXA2).
